# EUROPÄISCHE PATENTSCHRIFT

(11) **EP 1 447 696 B1**
(45) Veröffentlichungstag und Bekanntmachung des Hinweises auf die Patenterteilung: **30.07.2008**
(21) Anmeldenummer: 03090030.2
(22) Anmeldetag: 04.02.2003
(51) Int. Cl.: G02B 6/42

(54) **Modulares optoelektronisches Bauelement**
Modular optoelectronic component
Composant optoéléctronique modulaire

(43) Veröffentlichungstag der Anmeldung: 18.08.2004
(73) Patentinhaber: Avago Technologies Fiber IP (Singapore) Pte. Ltd., Singapore 768923 (SG)
(72) Erfinder: Wittl, Josef, 92331 Parsberg (DE); Hurt, Hans, 93049 Regensburg (DE)
(74) Vertreter: Dilg, Haeusler, Schindelmann Patentanwaltsgesellschaft mbH

(56) Entgegenhaltungen:
- EP-A- 0 690 319
- EP-A- 0 938 005
- EP-A- 1 168 022
- WO-A-96/34413
- DE-A- 10 065 034
- DE-A- 19 536 689
- US-A- 5 737 458
- US-A- 6 115 521
- US-B1- 6 302 596
- JÖRG WIRTGEN: "Leise Alleskönner" C'T MAGAZIN FÜR COMPUTERTECHNIK, Nr. 6, 11. März 2002 (2002-03-11), Seiten 146-148, XP002249278
- ADVA OPTICAL: "FSP-II Datasheet" ADVA OPTICAL NETWORKING, [Online] Juli 2001 (2001-07), XP002249279 Gefunden im Internet: <URL:www.advaoptical.com/Datasheets/FSP-II .pdf> [gefunden am 2003-07-24]

## Beschreibung

Bezeichnung der Erfindung: Optoelektronisches Bauelement zur Verwendung in einem modularen System optoelektronischer Bauelemente

Im Stand der Technik bekannte optoelektronische Bauelemente sind nicht in einfacher Weise unterschiedlich miteinander kombinierbar. Unterschiedliche, zum Teil kundenspezifische Applikationen erfordern daher einen hohen individuellen Arbeits- und Designaufwand. Gleiches gilt für mit optoelektronischen Bauelementen verbundene elektrische Schnittstellenelemente und Kabelstecker. Trotz eines hohen Maßes an Produkt- und Variantenvielfalt besteht eine nur geringe Flexibilität in der Produktion und im Systemdesign. Nachteilig ist die Verwirklichung spezifischer Applikationen dementsprechend mit hohen Kosten verbunden.

Ein weiterer Nachteil bekannter optoelektronischer Bauelemente besteht darin, dass sie in der Regel relativ breit sind. Damit besteht keine oder eine nur eingeschränkte Verwendbarkeit insbesondere in der Automobiltechnik und in der Multimediavernetzung. Hier werden häufig optoelektronische Bauelemente verlangt, die bei hoher Integrationsdichte eine nur geringe Breite aufweisen und gleichzeitig einfach und kostengünstig herstellbar sind.

Aus der DE 199 32 430 A1 ist eine opto-elektronische Baugruppe bekannt, bei der auf einem ersten Bauteil in einer Aufnahmenut ein Lichtwellenleiter angeordnet ist. Ein zweites Bauteil trägt einen optischen Sender und einen optischen Empfänger. Die beiden Bauteile werden so aufeinandergesetzt, dass der optische Sender und der optische Empfänger optisch mit dem Lichtwellenleiter gekoppelt sind, wozu zusätzlich zwei Spiegel vorgesehen sind, die das Licht um 90° umlenken. Die bekannte Baugruppe ist relativ groß und eignet sich nicht für eine Kombination mit anderen Baugruppen.

WO 96/34413 offenbart eine verkapselte Optokomponente, die eine Optokomponentenanordnung mit einer optischen Schnittstelle an einer Seite aufweist, die Führungspins zum Positionieren einer angeschlossenen optischen Komponente oder eines angeschlossenen optischen Konnektors aufweist. Die Anordnung ist an dem äußersten Abschnitt einer flexiblen Zunge angebracht, die integraler Teil eines dielelektrischen Trägers wie zum Beispiel eines Polymerträgers ist. An oder im Inneren des Trägers und der Zunge davon sind elektrisch leitfähige Pfade angeordnet, die an die Optoanordnung und an elektrische Treiberschaltkreise in einer Treiberschaltkreisanordnung angeschlossen sind, so dass der Träger auch die Funktion eines herkömmlichen Leadframe hat. Das gesamte Gerät ist in ein verkapselndes Plastikmaterial eingegossen. In dem Gießbetrieb ist die Positionierung der Optoanordnung in einer genau bestimmten Position, und das Verbleiben in dieser Position wird durch die Flexibilität der Zunge vereinfacht, die zum Beispiel nicht durch die Tatsache beeinflusst wird, dass ein injiziertes Verkapselungsmaterial möglicherweise die wesentlich größere Treiberschaltkreisanordnung und deren Befestigungsbereich an dem Träger verschiebt.

EP 0,690,319 offenbart einen Angrenzwellenleiter und einen optischen Konnektor. Ein Wellenleiter wird mit einer ersten Endfläche, einer zweiten Endfläche und einer Angrenzfläche gebildet. Der Angrenzwellenleiter enthält ferner einen Kernbereich, der sich von der ersten Endfläche zu der zweiten Endfläche erstreckt, und enthält einen Hüllenbereich, der den Kernbereich umgibt. Die erste Endfläche und die zweite Endfläche des Wellenleiters legen einen Abschnitt des Kernbereichs frei, der zum optischen Koppeln verwendet wird. Die angrenzende Fläche bildet eine Anschlussfläche für einen anderen Wellenleiter.

Der Erfindung liegt die Aufgabe zu Grunde, ein optoelektronisches Bauelement zur Verfügung zu stellen, das in einfacher Weise mit anderen Bauelementen gleicher Bauart kombinierbar ist und zwecks eines Einsatzes insbesondere in der Automobiltechnik und in der Multimediavernetzung bei kostengünstiger Herstellung eine nur geringe Breite aufweist.

Diese Aufgabe wird erfindungsgemäß durch ein optoelektronisches Bauelement mit den Merkmalen des Anspruchs 1 gelöst. Bevorzugte und vorteilhafte Ausgestaltungen der Erfindung sind in den Unteransprüchen angegeben.

Danach ist ein optoelektronisches Bauelement bereitgestellt mit einem Sende- und/oder Empfangsmodul, einem Schaltungsträger, auf dem das Sende- und/oder Empfangsmodul angeordnet ist, und einem Gehäuse, das durch den Schaltungsträger ausgebildet wird, wobei in das Bauelement ein mit dem Sende- und/oder Empfangsmodul gekoppelter Lichtwellenleiter integriert ist, der parallel zu dem Schaltungsträger verläuft und an einer schmalen Gehäuseseite eine optische Schnittstelle des Bauelements zur Ein- und/oder Auskopplung von Licht ausbildet. Die elektrischen Kontakte des Bauelements sind ebenfalls an einer schmalen Gehäuseseite angeordnet, wobei das Bauelement eine Abdeckung aufweist, die Mittel zur mechanischen Verbindung mit dem durch den Schaltungsträger gebildeten Gehäuse aufweist, der Schaltungsträger Balken aufweist, womit Seitenflächen an Schmalseiten des Bauelements gebildet sind, wobei eine zwischen den Balken offene Oberseite des Schaltungsträgers mit der Abdeckung abdeckbar ist, und wobei zwecks Bereitstellung eines modularen Systems auf einer breiten Unterseite des durch den Schaltungsträger gebildeten Gehäuses und auf den Balken auf einer breiten Oberseite des durch den Schaltungsträger gebildeten Gehäuses Mittel zur mechanischen Verbindung mit mindestens einem Gehäuse eines weiteren Bauelements oder mit der Abdeckung vorgesehen sind.

Das erfindungsgemäße optoelektronische Bauelement stellt einen besonders schmalen Transceiveraufbau bereit, dessen Schnittstellen an schmalen Seiten des Bauelements liegen. Dies erlaubt die Verwirklichung eines geringen Abstand zwischen den optischen Achsen zweier benachbarter Bauelemente, die beispielsweise einen Transceiver bilden. Ein weiterer Vorteil besteht darin, dass ein einfaches Redesign des Bauelements durch ein Redesign lediglich des Schaltungsträgers erfolgen kann. Bei im Stand der Technik bekannten Leadframe-Lösungen, bei denen Sende- und/oder Empfangsmodule auf einem Leadframe angeordnet und dann klar vergossen oder gemouldet werden, sind dagegen relativ aufwendige Leadframe Redesigns erforderlich.

Die erfindungsgemäße Lösung erlaubt des weiteren eine hohe Intergrationsdichte im Gehäuse. Weitere elektrische Komponenten wie Controller Chips oder Kondensatoren können problemlos auf den Schaltungsträger mit aufgebracht und damit in das Bauelement mit integriert werden. Damit werden auch Systemlösungen möglich.

Die Mittel zur mechanischen Verbindung sind in einer bevorzugten Ausgestaltung der Erfindung als mechanische Verbindungselemente ausgebildet, die eine steckbare Verbindung der Gehäuse ermöglichen, insbesondere als Rastelement, Formschlußelement oder Befestigungsstift. So handelt es sich bei den Verbindungsmitteln beispielsweise um Rasthaken, Führungsnuten, Stifte oder ähnliches. Diese Befestigungsmittel erlauben die unmittelbare mechanische Verbindung zweier Gehäuse bzw. zweier Bauelemente.

Ein Gehäuse kann dabei jede eine Außenfläche des Bauelements bildende Struktur sein. Beispielsweise kann das Gehäuse durch einen dreidimesionalen Schaltungsträger gebildet sein, der zusätzlich die Funktion eines Gehäuses erfüllt.

In einer alternativen bevorzugten Ausgestaltung sind die Mittel zur mechanischen Verbindung als Umgehäuse ausgebildet, das eine Vielzahl von Bauelementen aufnimmt. Die Bauelemente sind dabei in das Umgehäuse eingebaut und insofern mit diesem verbunden. Auch auf diese Weise wird ein verbessertes Handling erreicht. Das Umgehäuse kann dabei zusätzliche Funktionalitäten verwirklichen, insbesondere eine elektrische Schirmung des Gesamtmoduls vornehmen oder als Kühlkörper wirken. Durch Bereitstellung mehrerer Umgehäuse unterschiedlicher Breite können in einfacher Weise verschiedene Kombinationsmöglichkeiten der Bauelemente geschaffen werden. Auch kann vorgesehen sein, dass die Umgehäuse durch mechanische Verbindungsmittel mit weiteren Umgehäusen kombinierbar sind.

Bevorzugt weist das Gehäuse die Form eines Quaders auf, wobei jeweils zwei Gehäuse an einer Gehäuseseite unmittelbar aneinander anordbar sind. Die Quaderform ermöglicht in besonders einfacher Weise eine Aneinanderreihung mehrerer Bauelemente.

Die Bauelemente sind dabei bevorzugt an ihren breiten Gehäuseseiten miteinander verbindbar. Es wird dementsprechend ein sehr schmales, flaches Bauelement zur Verfügung gestellt. Bei Zusammenstecken mit weiteren entsprechenden Bauelementen liegen die optischen Achsen benachbarter optischer Schnittstellen sehr nahe beieinander, so dass Sender-, Empfänger und Transceiverleisten mit einer hohen Integrationsdichte bei insgesamt geringer Breite hergestellt werden können.

Bevorzugt werden die einzelnen optoelektronischen und elektrischen Module in SMD Technologie (Oberflächenmontage) auf dem Schaltungsträger montiert, so dass ein kostengünstiger und einfacher Aufbau vorliegt.

Die Bauelemente selbst sind bevorzugt steckbar mit einer Hauptschaltungsplatine verbindbar, wobei der Schaltungsträger des Bauelements senkrecht zur Ebene des Hauptschaltungsträgers verläuft. Die steckbare Verbindung erfolgt dabei über die elektrischen Kontakte des Bauelements, die beispielsweise als Einpresskontakte, alternativ als Lötkontakte oder SMT Kontakte ausgebildet sind.

Die Bauelemente können beispielsweise eindimensional zu einer Senderleiste, einer Empfängerleiste oder einer Transceiverleiste, etwa für parallele optische Verbindungen zusammengesetzt werden. Neben einer individuellen Kombinationsvielfalt besteht gegenüber Lösungen, in denen eine Sender-, Empfänger- oder Transceiverleiste einstückig hergestellt wird, der Vorteil, dass beim Ausfall eines Senders/Empfängers/ Transceivers das schadhafte Teil isoliert ausgewechselt werden kann. Ebenso kann eine zweidimensionale Verknüpfung der Komponenten erfolgen.

In einer bevorzugten Ausgestaltung ist das Gehäuse quaderförmig mit vier schmalen Seiten und zwei breiten Seiten ausgebildet. An den schmalen Seiten befinden sich die optische Schnittstelle und die elektrischen Kontakte.

Die an der einen Schmalseite des Bauelements ausgebildete optische Schnittstelle weist bevorzugt eine in die Schmalseite integrierte Steckeraufnahme zur Ankopplung eines optischen Steckers auf, so dass eine solche Ankopplung in einfacher Weise möglich ist. Bei der Steckeraufnahme handelt es sich beispielsweise um eine vorstehende Hülse, auf die ein optischer Stecker aufsteckbar ist, oder um ein festes Stück Lichtwellenleiter, das gegenüber dem Schaltungsträger vorsteht.

In einer weiteren Ausführungsform ist die optische Schnittstelle des Bauelements in der Gehäuseseite, in der sie sich befindet, nach hinten versetzt angeordnet. Beispielsweise wird ein starrer Lichtwellenleiter verwendet, der über den bestückten Schaltungsträger hinausragt, jedoch gleichzeitig gegenüber der Oberfläche der zugehörigen Gehäuseseite zurücksteht. Alternativ ist der Schaltungsträger mit einem hervorragenden Teilbereich ausgebildet, der den Lichtwellenleiter enthält, wobei der Teilbereich wiederum gegenüber der Oberfläche der zugehörigen Gehäuseseite zurücksteht.

Hintergrund ist, dass es erstrebenswert ist, eine Steckverbindung zwischen einem optischen Stecker und dem Bauelement derart zu gestalten, dass die Faserstirnfläche auch bei einem versehentlich falschen Stecken oder einem so genannten "blinden" Stecken nicht verschmutzt und sicher geschützt wird. Hierzu ist das sogenannte "Kojiri"-Kriterium bekannt, nach dem die Faser in einer Art "Schwertschaft" (japanisch: kojiri) geschützt wird. Dabei ist der anzukoppelnde Lichtwellenleiter im Stecker etwas zurückversetzt, um den anzukoppelnden Lichtwellenleiter zu schützen, und umfasst der Stecker beim Ankoppeln an das Bauelement die Lichtwellenleiterverlängerung des Schaltungsträgers.

Die Erfindung wird nachfolgend unter Bezugnahme auf die Figuren der Zeichnung anhand mehrerer Ausführungsbeispiele näher erläutert. Es zeigen:
- Figur 1: schematisch ein optoelektronisches Bauelement, das in einem modularen System einsetzbar ist und eine optische Schnittstelle sowie elektrische Kontakte aufweist;
- Figur 2: eine perspektivische Darstellung einer Ausgestaltung eines optoelektronischen Bauelements gemäß Figur 1;
- Figur 3: eine perspektivische Darstellung eines optoelektronischen Bauelements in CAI-Bauform;
- Figur 4: ein Sendebauelement und ein Empfangsbauelement, die mechanisch miteinander verbunden sind und ein Transceiverbauelement bilden;
- Figur 5: ein lineares Modul mit einer Vielzahl von Transceiverbauelementen gemäß Figur 4 und einem elektrischen Steckerbauelement, die mechanisch miteinander verbunden sind;
- Figur 6a: eine Vielzahl von in einer Reihe angeordneter Bauelemente gemäß Fig. 2, die durch ein Umgehäuse mechanisch miteinander verbunden sind;
- Figur 6b: eine Vielzahl von in einer Reihe angeordneter Bauelemente gemäß Fig. 3, die durch ein Umgehäuse mechanisch miteinander verbunden sind;
- Figur 7: eine erste zweidimensionale Anordnung von optoelektronischen Bauelementen, wobei die elektrischen Kontakte als Löt- oder Einpresskontakte ausgebildet sind;
- Figur 8: eine zweite zweidimensionale Anordnung von optoelektronischen Bauelementen, wobei die elektrischen Kontakte als BGA-Kontakte ausgebildet sind;
- Figur 9a: in Seitenansicht ein Sende- und ein Empfangsbauelement, die mechanisch miteinander verbunden sind und zusammen einen Quader bilden;
- Figur 9b: eine Frontansicht mehrerer nebeneinander angeordneter Sende- und Empfangsbauelemente gemäß Figur 9a;
- Figur 10: einen mit einem optischen Kabel verbundenen optischen Stecker, der mechanisch mit weiteren Steckern verbindbar ist;
- Figur 11: einen mit einem elektrischen Kabel versehenen elektrischen Stecker, der mit weiteren (elektrischen oder optischen) Steckern mechanisch verbindbar ist;
- Figur 12: den Einbau mehrerer Stecker gemäß den Figuren 10 und 11 in einem gemeinsamen Umgehäuse, das eine mechanische Verbindung der einzelnen Stecker bereitstellt;
- Figur 13: einen Querschnitt durch ein schmal ausgebildetes optoelektronisches Bauelement mit integriertem Lichtwellenleiter;
- Figur 13a: ein Sende- und/oder Empfangsmodul des Bauelements der Figur 13;
- Figur 13b: eine perspektivische Draufsicht auf die eine Seite des Schaltungsträgers der Figur 13;
- Figur 13c: eine perspektivische Draufsicht auf die andere Seite des Schaltungsträgers der Figur 13;
- Figur 14: die Anordnung des Schaltungsträgers und der darauf angeordneten Komponenten in einem durch eine Abdeckung abgedeckten Umgehäuse;
- Figur 15: die Anordnung zweier schmal ausgebildeter optoelektronischer Bauelemente nebeneinander auf einem Hauptschaltungsträger;
- Figur 16: eine Anordnung gemäß Figur 13, wobei sich in einer Bohrung des Schaltungsträgers eine Linse befindet;
- Figur 17: eine alternative Ausgestaltung eines optoelektronischen Bauelementes, bei dem ein optisches Sende- und/oder Empfangselement auf der gleichen Seite einer Schaltungsplatine angeordnet ist wie der integrierte Lichtwellenleiter;
- Figur 18: eine Transceiveranordnung, bei der eine Schaltungsplatine mit einem Sendebauelement und eine Schaltungsplatine mit einem Empfangsbauelement in ein gemeinsames Gehäuse eingesetzt sind;
- Figur 19: in schematischer Seitenansicht eine alternative Ausgestaltung eines Umgehäuses, bei dem das Gehäuse des optischen Bauelementes gegenüber der optischen Schnittstelle hervorsteht;
- Figur 20: eine weitere Ausgestaltung eines optoelektronischen Bauelementes, bei dem ein optisches Sende- und/oder Empfangsbauelement auf der gleichen Seite eines Schaltungsträgers angeordnet ist;
- Figur 21a: eine Ausgestaltung eines optoelektronischen Bauelementes gemäß einem exemplarischen Ausführungsbeispiel der Erfindung, bei der der Schaltungsträger in MID-Bausweise ausgeführt ist; und
- Figur 21b: mehrere miteinander verbundene Bauelemente gemäß Figur 21a.

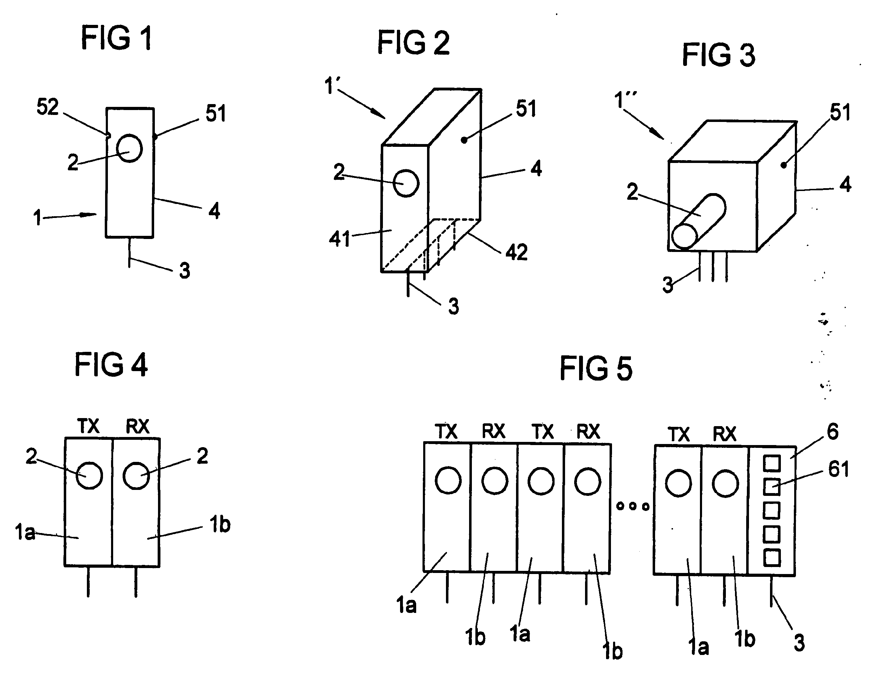

Die Figur 1 zeigt schematisch ein optoelektronisches Bauelement 1, das eine Grundkomponente eines modularen Systems optoelektronischer Bauelemente darstellt. Bei dem Bauelement 1 handelt es sich um ein Sendebauelement mit einem optischen Sendeelement wie einer Laserdiode oder einer LED, um ein Empfangsbauelement mit einem optischen Empfangselement wie einer Fotodiode oder um ein Sende- und Empfangsbauelement (Transceiver) mit einem Sende- und einem Empfangselement.

Das Bauelement 1 weist eine optische Schnittstelle 2 zur Einund Auskopplung von Licht in bzw. aus dem Bauelement 1 auf. Des Weiteren sind elektrische Kontakte 3 vorgesehen, die der elektrischen Kontaktierung des Bauelementes dienen. Insbesondere wird das Bauelement 1 mit den elektrischen Kontakten 3 auf einer Hauptschaltungsplatine angeordnet, über die das Bauelement 1 sowie weitere, auf einer solchen Hauptschaltungsplatine angeordnete Bauelemente elektrisch angesteuert werden. Die elektrischen Kontakte sind beispielsweise als Einpress-, Löt- oder SMT-Kontakte ausgebildet.

Das Bauelement 1 weist ein Gehäuse 4 auf, das die Außenbegrenzung des Bauelementes 1 definiert. Unter einem Gehäuse im Sinne der vorliegenden Erfindung wird dabei sowohl eine eigenständige Gehäusestruktur als auch die Außenstruktur eines Vergussmaterials verstanden, das optoelektronische Komponenten umhüllt.

Um das Bauelement 1 mechanisch mit weiteren, in gleicher Weise ausgebildeten Bauelementen 1 verbinden zu können, weist das Gehäuse 4 mechanische Verbindungselemente 51, 52 auf, die eine steckbare Verbindung des Gehäuses 4 mit anderen, entsprechenden Gehäusen ermöglichen. Die Verbindungselemente 51, 52 sind in Figur 1 lediglich schematisch und beispielhaft als ein vorstehendes Element 51 und eine Aussparung 52 dargestellt, die in ihren Formen miteinander korrespondieren. Bei Aneinanderreihung mehrerer Bauelemente 1 greifen die jeweils auf gegenüberliegenden Seiten eines Gehäuses angeordneten Verbindungselemente 51, 52 formschlüssig ineinander ein, so dass über sie eine mechanische Verbindung zweier Gehäuse bzw. Bauelemente 1 erfolgt.

Grundsätzlich können die mechanischen Verbindungselemente in beliebiger Weise, insbesondere als kraftschlüssige, formschlüssige oder kraft- und formschlüssige Verbindungselemente ausgeführt sein. Beispielsweise kann es sich um Rastelemente, Führungsnuten mit zugehörigen Führungsnasen sowie in Bohrungen geführte Befestigungsstifte handeln. Wesentlich ist allein, dass Mittel zur mechanischen Verbindung an dem Gehäuse 4 eines Bauelementes 1 vorgesehen sind, die eine mechanische Verbindung mit mindestens einem weiteren Gehäuse ermöglichen. Bevorzugt sind dabei jeweils auf gegenüberliegenden Seiten eines Gehäuses Verbindungselemente 51, 52 mit korrespondierenden Formen vorgesehen.

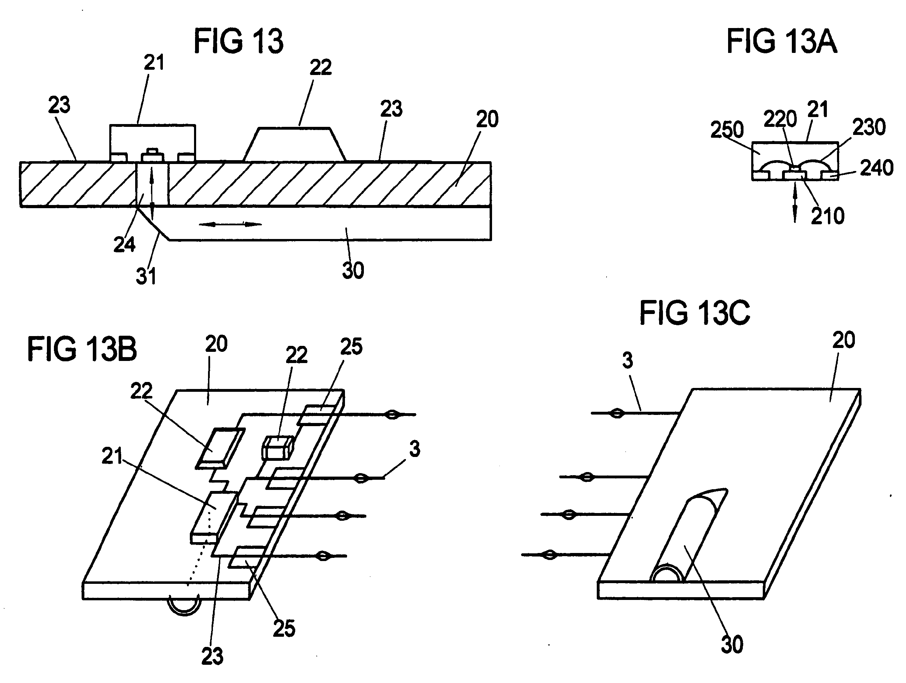

Die Figur 2 zeigt schematisch eine Ausführungsvariante eines Bauelementes gemäß Figur 1, bei der das Bauelement in Form eines langgestrecktern Quaders mit vier flachen Seitenflächen und zwei breiten Seitenflächen ausgebildet ist. Die optische Schnittstelle 2 und die elektrischen Kontakte 3 befinden sich dabei jeweils an zwei flachen Seitenflächen 41, 42 des Gehäuses 4. In der perspektivischen Darstellung der Figur 2 ist ein Verbindungselement 51 zur Verbindung des Gehäuses mit dem Gehäuse eines weiteren Bauelementes zu erkennen. Ein entsprechendes Verbindungselement befindet sich auf der gegenüberliegenden Seite des Bauelementes 1'. Ein dem Bauelement 1' entsprechendes Bauelement wird anhand der Figuren 13 bis 20 noch eingehend erläutert werden.

Die Figur 3 zeigt eine weitere Ausführungsvariante eines Bauelementes 1", das in CAI-Bauform (CAI = Cavity as Interface) ausgeführt ist. Dabei ist ein optoelektronisches Modul auf einem Leadframe angeordnet, der in das Gehäuse 4 eingeführt und in diesem mit einem Vergussmaterial vergossen wird. Zum kontrollierten Einführen des Leadframes in das Gehäuse 4 sind bevorzugt Führungsnuten im Gehäuse vorgesehen. Bauelemente in CAI-Bauform sind beispielsweise aus der DE 199 09 242 A1 bekannt.

Das Gehäuse 4 der Ausführungsform der Figur 3 ist quaderförmig ausgebildet. Die optische Schnittstelle ist in Form eines vorstehenden Wellenleiterabschnitts 2 ausgebildet, der mit einem optischen Stecker koppelbar ist. Des Weiteren ist wiederum ein Verbindungselement 51 zur Verbindung des Bauelementes 1" mit weiteren, entsprechenden Bauelementen vorgesehen. Die elektrischen Kontakte 3 liegen anders als bei der Figur 2 in oder parallel zur Bildebene. Gleiches gilt für das in das Gehäuse 4 eingeführte Leadframe (nicht dargestellt).

Der innere Aufbau der in den Figuren 1 bis 3 dargestellten Bauelemente kann auf vielfältige Art und Weise erfolgen. Beispielsweise wird eine CAI-Bauform wie in Bezug auf Figur 3 beschrieben verwendet. Insbesondere bei flach ausgebildeten Bauelementen 1' gemäß Figur 2 ist dagegen bevorzugt vorgesehen, ein optoelektronisches Modul sowie ggf. weitere elektrische Bauelemente auf einer Schaltungsplatine anzuordnen, bei der die optische Schnittstelle über einen mit dem optoelektronischen Modul gekoppelten und parallel zur Schaltungsplatine verlaufenden Lichtwellenleiter realisiert wird.

Auch sind SMT-Bauelemente beliebiger Bauart einsetzbar, die oberflächenmontiert auf einer Hauptschaltungsplatine anordbar sind. Wesentlich für die Bauelemente 1 ist das Vorliegen eines standardisierten Gehäuses mit Mitteln zur mechanischen Verbindung mit mindestens einem weiteren Gehäuse. Diese Funktionalität erlaubt den Einsatz der Bauelemente als Basiskomponenten eines modularen Systems optoelektronischer Bauelemente. Das Innenleben der Bauelemente, d.h. die technische Realisierung einer optoelektronischen Signalwandlung sowie die Realisierung der Schnittstellen kann grundsätzlich in beliebiger Art und Weise erfolgen.

Die Figur 4 zeigt ein Transceivermodul, das aus zwei Bauelementen 1a, 1b zusammengesetzt ist, deren Gehäuse mechanisch miteinander verbunden sind (nicht gesondert dargestellt). Bei dem einen Bauelement handelt es sich dabei um ein Sendebauelement TX und bei dem anderen Bauelement um ein Empfangsbauelement RX. Durch die Anordnung in einem schmalen Gehäuse kann erreicht werden, dass der Abstand der optischen Achsen der jeweiligen optischen Schnittstellen 2 nur gering ist.

Gemäß Figur 5 lassen sich die Sendebauelemente 1a, 1b zu einer Transceiverleiste variabler Länge zusammenstecken. Je nach der gewünschten Anwendung kann somit in einfacher Weise auf der Basis der Grundkomponenten 1a, 1b eine Transceiverleiste etwa für parallele optische Verbindungen bereitgestellt werden. Ebenso kann natürlich auch eine lineare Anordnung lediglich von Sendebauelementen oder von Empfangsbauelementen erfolgen. In Figur 5 ist auch ein elektrisches Schnittstellenelement 6 dargestellt. Dieses ist über Kontakte 3 ebenso wie die optoelektronischen Bauelemente mit einer Schaltungsplatine verbindbar. Gleichzeitig werden elektrische Kontakte 61 beispielsweise für einen anzukoppelnden elektrischen Stecker bereitgestellt. Die Außenkonturen des Schnittstellenelementes 6 entsprechen den Außenkonturen der optoelektronischen Bauelemente 1a, 1b. Des Weiteren weist das Schnittstellenelement 6 ebenso Mittel zur mechanischen Verbindung mit den Gehäusen anderer Komponenten auf, so dass eine beliebige Verbindung mit den optoelektronischen Bauelementen erfolgen kann.

Es wird darauf hingewiesen, dass die einzelnen Komponenten eine maschinenlesbare Beschriftung aufweisen können, wodurch eine hoch automatisierte Produktion der Gesamtmodule, auch in unterschiedlichsten Kombinationen realisierbar ist. Des Weiteren kann vorgesehen sein, dass die Komponenten eine farbliche Kennzeichnung aufweisen, die ihre Zugehörigkeit zu einer bestimmten Klasse von Komponenten oder ihre Verbindbarkeit mit anderen Komponenten angibt. Dies erleichtert eine manuelle Montage der Einzelkomponenten zu Gesamtmodulen als auch eine visuelle Kontrolle nach einer automatischen Fertigung. Durch eine Erweiterung einer farblichen Kennzeichnung auf zusätzliche Systemkomponenten wie Stecker und Kabel kann die Korrektheit der Zuordnung der einzelnen Komponenten leicht überprüft werden.

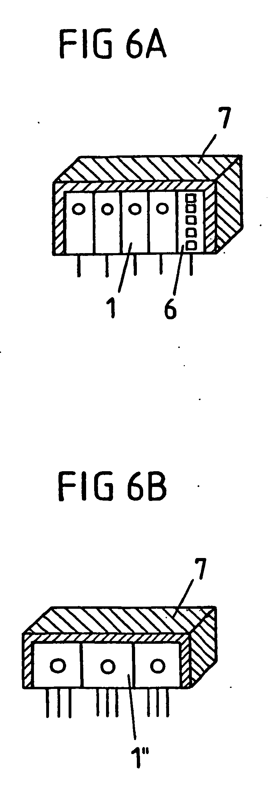

Die Figur 6a zeigt die lineare Anordnung mehrerer optoelektronischer Bauelemente 1 gemäß Figur 1 und einem (optionalen) Schnittstellenelement 6 gemäß Figur 5. Bei dieser Ausführungsform sind die einzelnen Bauelemente 1, 6 durch ein Umgehäuse 7 miteinander verbunden, d.h. das Umgehäuse 7 dient der gemeinsamen Anordnung und Verbindung der einzelnen Bauelemente 1, 6. Bei Verwendung eines Umgehäuses 7 kann auf an den einzelnen Gehäusen vorgesehene mechanische Verbindungselemente verzichtet werden, so dass insofern eine alternative Ausgestaltung zu der Ausgestaltung der Figur 5 vorliegt. Ebenso kann jedoch vorgesehen sein, dass das Umgehäuse 7 lediglich als zusätzliche Maßnahme zur mechanischen Verbindung der einzelnen Bauelemente 1, 6 vorgesehen ist und diese entsprechend Figur 1 jeweils mechanische Verbindungselemente zur Verbindung mit anderen Gehäusen aufweisen. Des Weiteren kann vorgesehen sein, dass mehrere Umgehäuse untereinander über mechanische Verbindungselemente wie Rastelemente, Formschlusselemente oder Befestigungsstifte miteinander verbindbar sind, entsprechend der Verbindung der einzelnen Bauelemente 1, 6.

Die Verwendung eines Umgehäuses kann zur Realisierung zusätzlicher Funktionalitäten genutzt werden. Insbesondere ist bevorzugt vorgesehen, dass das Umgehäuse 7 metallisch leitend ist und eine elektromagnetische Abschirmung des Gesamtmoduls bereitstellt. Des Weiteren kann das Umgehäuse 7 als Kühlkörper verwendet werden, wozu beispielsweise spezielle Strukturen auf den Kühlkörper aufgebracht werden (nicht dargestellt) oder eine Wärmesenke angebunden wird (nicht dargestellt).

Das Ausführungsbeispiel der Figur 6b zeigt in linearer Anordnung mehrere Bauelemente 1" in CAI-Bauform gemäß Figur 3 mit einem Umgehäuse 7. Die Erläuterungen zu Figur 6a gelten entsprechend.

In einer weiteren Ausgestaltung werden die einzelnen Bauelemente 1, 6 durch Kleben miteinander verbunden. Der Klebstoff stellt dabei ein Mittel zur mechanischen Verbindung der einzelnen Gehäuse bereit, mit denen die Gehäuse jeweils verbunden sind.

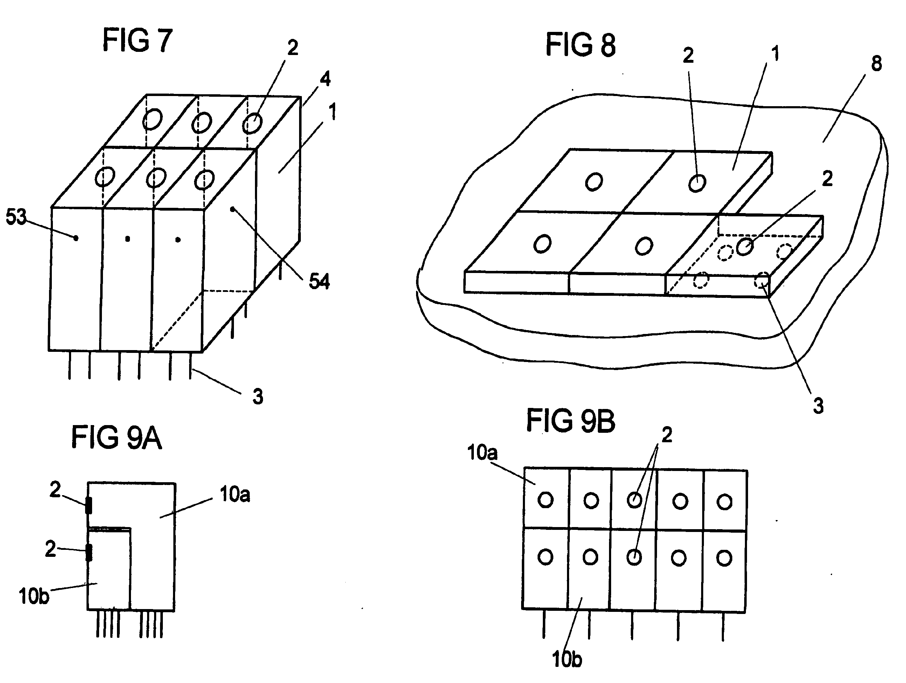

Bei dem Ausführungsbeispiel der Figur 7 sind mehrere optoelektronische Bauelemente 1 in einem zweidimensionalen Array angeordnet. Die optische Schnittstelle 2 und die elektrische Schnittstelle 3 mit elektrischen Anschlüssen sind dabei auf gegenüberliegenden Seiten des Gehäuses 4 angeordnet, und nicht auf senkrecht zueinander verlaufenden Seiten wie bei den Ausführungsbeispielen der Figuren 1 bis 6.

Durch eine zweidimensionale Verknüpfung einzelner Bauelemente 1 kann ein zweidimensionales Sender- oder Empfängerarray bereitgestellt werden.

Bei einer zweidimensionalen Anordnung weisen die einzelnen Bauelemente bevorzugt an vier Seiten Verbindungselemente 53, 54 (schematisch dargestellt) zur mechanischen Verbindung der Gehäuse der einzelnen Bauelemente 1 untereinander auf. Die Verbindungselemente befinden sich dabei an denjenigen Seiten der quaderförmigen Gehäuse 4, an denen die optische Schnittstelle 2 und die elektrischen Kontakte 3 nicht angeordnet sind. Die elektrischen Kontakte 3 sind bei dem Ausführungsbeispiel der Figur 7 als Löt- oder Einpresskontakte ausgebildet.

Die Figur 8 zeigt ebenfalls ein zweidimensionales Array von optoelektronischen Bauelementen 1, die jedoch wesentlich flacher insofern ausgebildet sind, als der Abstand zwischen der optischen Schnittstelle und der auf einer gegenüberliegenden Gehäuseseite angeordneten elektrischen Kontaktierung 3 wesentlich geringer ist. Die elektrischen Kontakte sind bei dieser Ausgestaltung zwecks einer Oberflächenmontage als BGA-Kontakte (BGA = ball grid array) ausgeführt. Die Bauelemente 1 sind auf einem Hauptschaltungsträger 8 oberflächenmontiert.

Die Figuren 9a und 9b zeigen ein Ausführungsbeispiel, bei dem eine Grundkomponente des modularen Systems durch ein Sendebauelement und/oder Empfangsbauelement bereitgestellt wird, die zusammen ein quaderförmiges Bauelement ausbilden, das mit weiteren, entsprechenden Bauelementen wiederum mechanisch verbindbar ist.

Dabei ist das Gehäuse des einen Bauelementes 10a winklig unter Ausbildung einer quaderförmigen Aussparung ausgebildet. Das Gehäuse des anderen Bauelementes 10b ist quaderförmig ausgebildet und zwar derart, dass es in die quaderförmige Aussparung des anderen Gehäuses einsetzbar ist, wobei insgesamt eine Quaderform entsteht. Die Gehäuse der beiden Bauelemente 10a, 10b sind dabei wiederum mechanisch miteinander verbunden. Die Zwischenschnittstellen 2 der beiden Bauelemente liegen auf der gleichen Gehäuseseite und bevorzugt übereinander. Die Figur 9b zeigt mehrere derartige Bauelemente in linearer Anordnung.

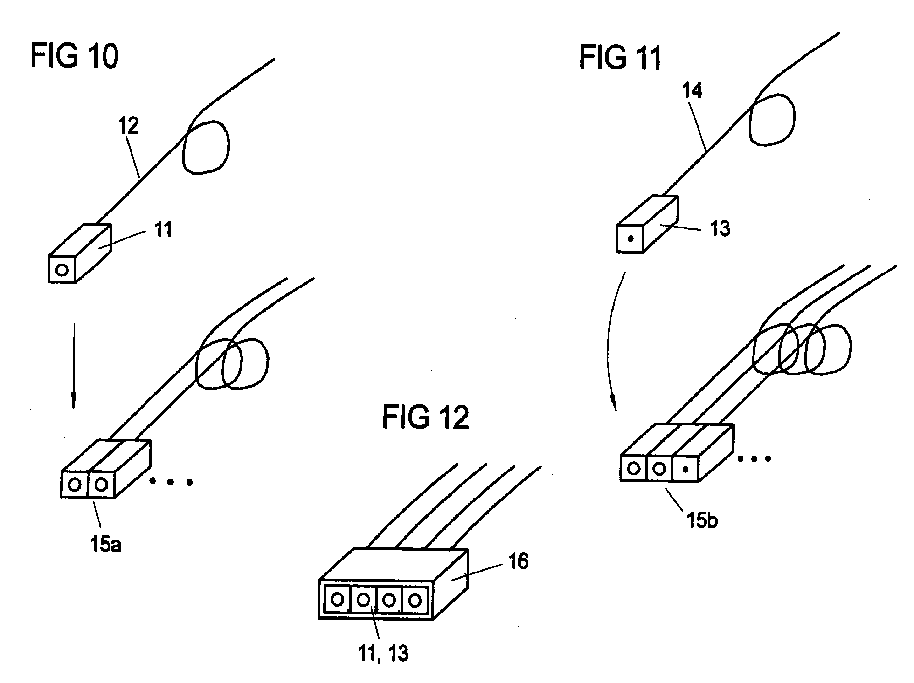

Als weitere Systemkomponenten des modularen Systems sind gemäß den Figuren 10 und 11 Stecker 11 für optische Kabel 12 (Figur 10) und elektrische Stecker 13 für elektrische Kabel 14 vorgesehen. Die Einzelstecker sind dabei jeweils zu Zwei oder Mehrfachsteckern kombinierbar, wozu die Steckergehäuse Mittel zur mechanischen Verbindung mit weiteren Steckergehäusen aufweisen, beispielsweise wiederum Rastelemente oder ähnliches. Entsprechende Mehrfachstecker 15a, 15b sind in Figuren 10 und 11 gezeigt, wobei auch optische und elektrische Stecker miteinander verbunden sein können.

Gemäß Figur 12 sind die einzelnen Stecker 11, 13 in ein gemeinsames Umgehäuse 16 eingebaut. Hierdurch erfolgt eine zusätzliche Fixierung der Stecker. Bevorzugt ist die Faser in jedem Einzelstecker 11, 13 zurückversetzt, um das Kojiri-Kriterium zu erfüllen. Alternativ ist eine zurückversetzte Anordnung der Stecker 11, 13 im Umgehäuse 16 zur Erfüllung des Kojiri-Kriteriums vorgesehen. Es wird darauf hingewiesen, dass das Umgehäuse 16 ebenso wie das Umgehäuse der Figuren 6a, 6b auch an einer Seite offen ausgebildet sein kann.

Die Figuren 13 bis 20 zeigen verschiedene Ausführungen eines flach ausgebildeten optoelektronischen Bauelementes entsprechend dem optoelektronischen Bauelement der Figur 2. Gemäß Figur 13 weist das Bauelement einen flach ausgebildeten Schaltungsträger 20 auf, auf dessen einen Seite ein optoelektronisches Sende- und/oder Empfangsmodul 21 sowie weitere elektrische Bauelemente 22 und auf dessen anderen Seite ein Lichtwellenleiter 30 angeordnet sind. Auf der Seite des Schaltungsträgers 20 mit den elektrischen und optoelektronischen Komponenten sind elektrische Leiterbahnen 23 auf dem Schaltungsträger 20 zwecks einer elektrischen Kontaktierung der Elemente 21, 22 vorgesehen.

Das Sende- und/oder Empfangsmodul 21 ist in Figur 13a näher dargestellt. Es weist ein auf einem Träger 210 angeordnetes optisches Bauelement 220 auf, bei dem es sich beispielsweise um eine Fotodiode, eine LED oder eine Laserdiode handelt. Je nach Bauelement liegt entweder ein Sendemodul oder ein Empfangsmodul vor. Die Kontaktierung des optischen Bauelements 210 erfolgt beispielsweise mittels zweier Bonddrähte 230, die mit elektrischen Kontakten 240 an der Unterseite des Moduls 21 verbunden sind, wobei über die elektrischen Kontakte 210 eine SMD-Montage des Moduls 21 auf dem Schaltungsträger 20 erfolgen kann.

In einer alternativen Ausgestaltung handelt es sich bei den Elementen 210, 220 sowohl um ein Empfangselement (Fotodiode) als auch um ein Sendeelement (LED-Laser). Beispielsweise ist das Sendeelement 220 oberhalb des Empfangselements 210 angeordnet und letzteres für die vom Sendeelement 220 ausgesandte Wellenlänge transparent. Bei einer solchen Ausgestaltung handelt es sich um ein Sende- und Empfangsmodul, das gleichzeitig Licht einer ersten Wellenlänge aussendet und Licht einer zweiten Wellenlänge detektiert, wobei grundsätzlich die beiden Wellenlängen identisch sein können. Die Komponenten des Moduls 21 sind in eine Pressmasse 250 eingespritzt. Die Unterseite (auf der Seite der elektrischen Kontakte 240) stellte einen optischen Zugang des Moduls bereit.

Die weiteren Bauelemente 22 sind bevorzugt ebenfalls SMD-Bauelemente. Es handelt sich beispielsweise um integrierte Treiberschaltungen, Vorverstärker oder Kondensatoren.

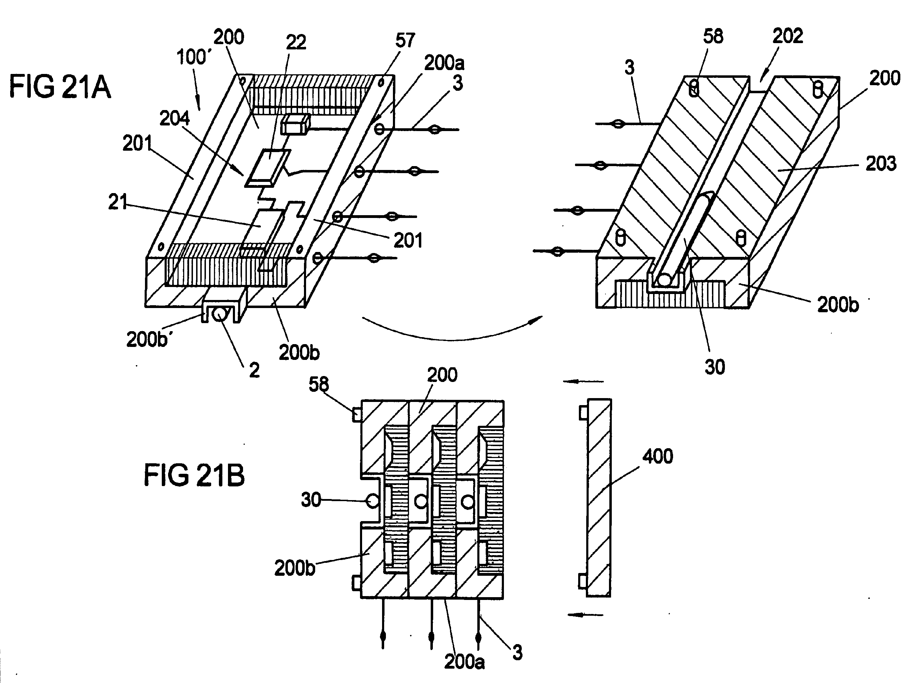

Der Schaltungsträger 20 kann zum einen als gedruckte Leiterplatte (PCB-printed circuit board) ausgebildet sein, die einseitig mit vorgefertigten elektrischen und optischen Bauelementen bestückt wird. Alternativ kann der Schaltungsträger auch als sogenanntes MID-Bauelement ausgebildet sein (MID - moulded interconnected device). Hierbei handelt es sich um ein aus Kunststoff gespritztes Formteil, das mit einem Laser derart modifiziert wird, dass direkt auf den Kunststoff Leiterbahnen ausgebildet werden können. Dieses Formteil kann (im Gegensatz zu einer Platine) zusätzlich die Funktion eines Gehäuses erfüllen. Ein Ausführungsbeispiel hierzu wird anhand der Figuren 21a, 21b beschrieben werden.

Der Lichtwellenleiter 30 kann ebenfalls in vielfältiger Weise ausgebildet sein. Zum einen kann es sich um eine Standard-Lichtleitfaser handeln, die auf den Schaltungsträger 20 aufgeklebt wird. In einer anderen Variante wird der Lichtwellenleiter durch direkte Laserstrukturierung (DLS - direct laser structuring) auf den Schaltungsträger 20 aufgebracht. Hierzu wird der Schaltungsträger mit einer Kunststoffschicht bedeckt, die in noch flüssigem Zustand mit einem Laser beschrieben wird, wobei die als Wellenleiter dienenden Bereiche aushärten und die restlichen Bereiche entfernt werden. Die optischen Bahnen bleiben dabei stehen. Es ist ebenfalls denkbar, ein klares Spritzgußteil, das ummantelt oder verspiegelt ist, als Lichtwellenleiter einzusetzen. Grundsätzlich sind auch andere Verfahren zur Ausbildung oder Anordnung eines Lichtwellenleiters am Schaltungsträger 20 denkbar.

Im Schaltungsträger 20 befindet sich eine Bohrung 24, durch die das Sende- und/oder Empfangsmodul 21 optisch mit dem Lichtwellenleiter 30 gekoppelt wird. Dabei erfährt der Lichtstrahl eine Strahlumlenkung von 90° an einer schräg verlaufenden Fläche 31 des Lichtwellenleiters.

Figur 13b zeigt die Komponenten der Figur 13 in perspektivischer Ansicht auf die mit den optischen und elektronischen Komponenten versehenen Seite des Schaltungsträgers 20. Dabei sind eine Mehrzahl von elektrischen Kontakten 3 (ausgeführt als Einpresskontakte) mit Verbindungspads 25 auf dem Schaltungsträger 20 verbunden, die wiederum mit den elektrischen Leiterbahnen 23 verbunden sind. Die elektrischen Kontakte 3 befinden sich in der gleichen Ebene wie der Schaltungsträger 20 und weisen senkrecht von der Seitenbegrenzung des Schaltungsträgers 20 weg.

Die Figur 13c zeigt die Schaltungsplatine von der anderen Seite. Diese Seite weist keine optischen oder elektrischen Bauelemente auf. Es ist lediglich der in das Bauelement integrierte Lichtwellenleiter 30 auf dieser Seite des Schaltungsträgers 20 angeordnet. Der Lichtwellenleiter 30 erstreckt sich dabei bis zu dem Rand des Schaltungsträgers 20 und bildet dort eine optische Schnittstelle aus.

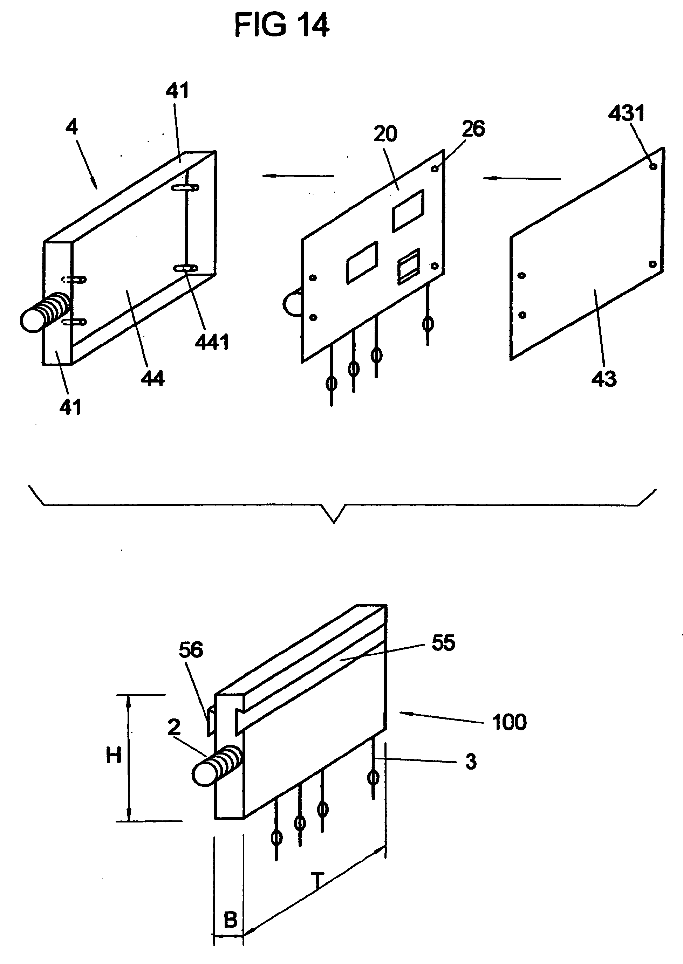

Gemäß Figur 14 wird der bestückte Schaltungsträger 20 in ein Gehäuse 4 eingesetzt. Das Gehäuse 4 weist einen umlaufenden, die Schmalseiten des Gehäuses definierenden Rahmen 41 und eine fest damit verbundene seitliche Wand 44 an der einen breiten Seitenfläche des quaderförmigen Gehäuses auf. An der feststehenden Wand 44 sind mehrere Positionier- und Haltepins 441 angeordnet, auf die der bestückte Schaltungsträger 20 und anschließend eine Abdeckung 43, die die andere breite Seitenfläche des Gehäuses 4 ausbildet, aufgesteckt wird. Hierzu weisen der Schaltungsträger 20 und die Abdeckung 43 entsprechend den Positionier- und Haltestiften 441 ausgebildete Löcher 26, 431 auf. Nach entsprechender Montage liegt ein optoelektronisches Bauelement 100 vor, das quaderförmig mit vier schmalen Seiten und zwei breiten Seiten ausgebildet ist. Die optische Schnittstelle 2 und die elektrischen Kontakte 3 sind dabei jeweils an einer schmalen Seite des quaderförmig ausgebildeten Bohrelementgehäuses angeordnet.

Die optische Schnittstelle 2 wird im dargestellten Ausführungsbeispiel durch eine integrierte Steckeraufnahme in Form einer vorstehenden Hülse gebildet, an die ein optischer Stecker ankoppelbar ist. Dies erleichtert die Ankopplung eines optischen Steckers.

Optional kann das Gehäuse des Bauelementes 100, wie in Figur 14 unten dargestellt, das Gehäuse des Bauelementes 100 mechanische Verbindungselemente aufweisen, die eine Verbindung mit weiteren, entsprechenden Bauelementen 100 ermöglichen, so dass das optoelektronische Bauelement im Rahmen des zuvor beschriebenen modularen Systems einsetzbar ist. Die mechanischen Verbindungselemente können dabei grundsätzlich auf beliebige Art und Weise verwirklicht sein. Als Beispiel hierzu ist in Figur 14 eine trapezförmige Aussparung 35 auf der einen breiten Seitenfläche des Gehäuses ausgebildet. Auf der anderen Seite befindet sich ein in seiner Form korrespondierender, trapezförmiger Vorsprung 36. Durch Längsverschiebung können aneinander angrenzende Bauelemente somit formschlüssig miteinander verbunden werden.

Das Bauelement 100 weist bevorzugt eine Höhe H zwischen 0,5 und 1,5 cm, eine Tiefe T zwischen 0,5 und 2 cm und eine Breite B zwischen 3 und 7 mm auf, wobei diese Angaben nur beispielhaft zu verstehen sind.

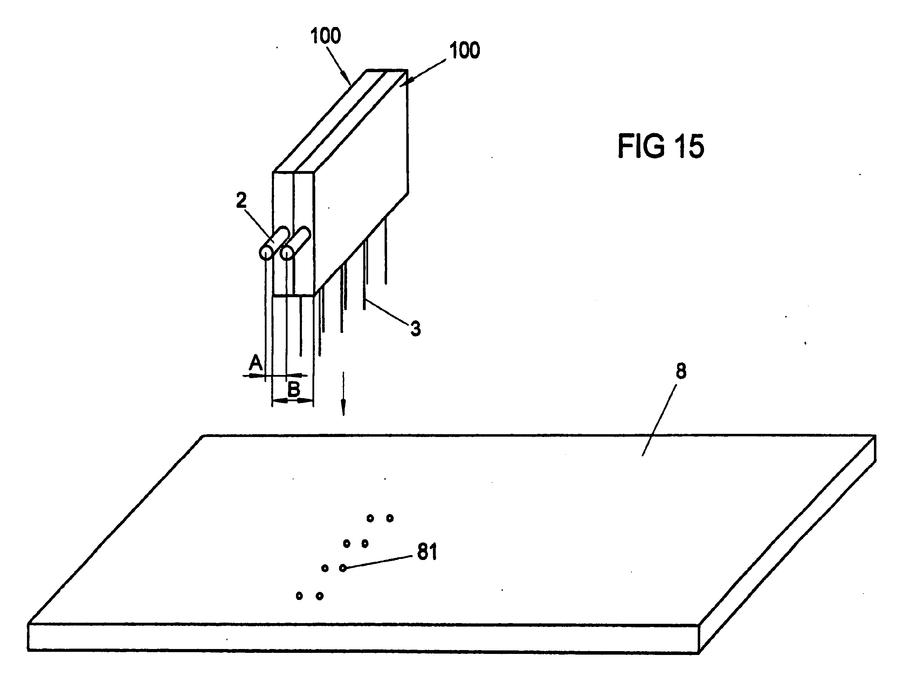

Figur 15 zeigt zwei mechanisch miteinander verbundene Bauelemente 100. Aufgrund der flachen Ausbildung der Bauelemente ist der Abstand A der optischen Achsen der jeweiligen Lichtwellenleiter sehr gering. Auch ist die Gesamtdicke aufgrund der geringen Dicke der einzelnen Bauelemente 100 gering. Sofern das eine Bauelement 100 ein Sendebauelement und das andere Bauelement 100 ein Empfangsbauelement ist, ergibt sich insgesamt ein kompakt ausgebildeter Transceiver schmaler Bauart. Der Transceiver wird mittels der elektrischen Kontakte auf einem Hauptschaltungsträger 8 befestigt, wozu die Kontakte 3 beispielsweise in entsprechende Öffnungen 81 des Hauptschaltungsträgers eingepresst oder gelötet werden. Dabei wird darauf hingewiesen, dass aufgrund des Umstandes, dass die elektrischen Kontakte aus einer Längsseite des Bauelementes 100 austreten, in relativ großer Anzahl vorgesehen werden können.

Ggf. können auf dem Hauptschaltungsträger 8 eine Vielzahl entsprechender Transceiver angeordnet und dabei miteinander verbunden sein, entsprechend der Anordnung der Figur 5.

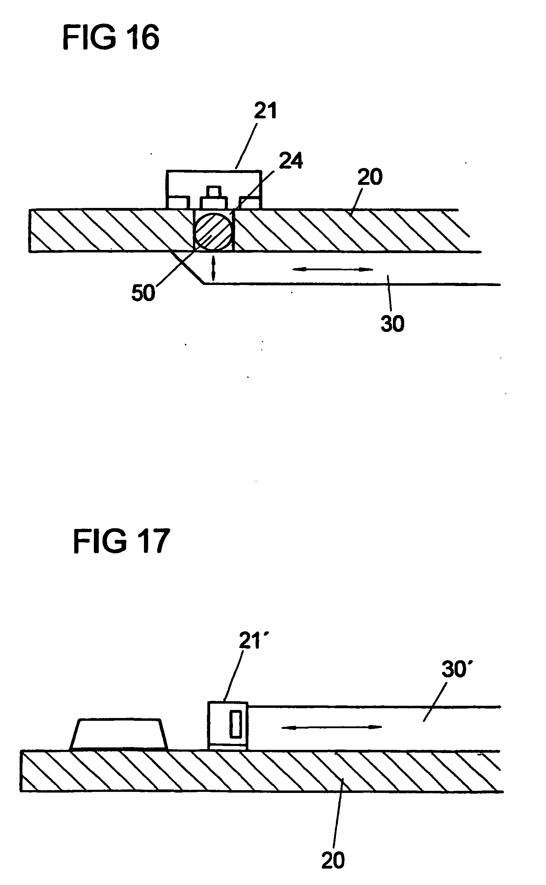

In dem Ausführungsbeispiel der Figur 16 ist in die Aussparung 24 des Schaltungsträgers 20 eine Koppellinse 50 integriert, die einer besseren optischen Ankopplung zwischen optoelektronischem Modul 21 und Lichtwellenleiter 30 dient.

Die Figur 17 sieht eine Ausgestaltung vor, bei der das Sendeund/oder Empfangsmodul 21' und der Lichtwellenleiter 30' auf der gleichen Seite des Schaltungsträgers 20 angeordnet sind. Das Modul 21' weist dabei eine parallel zum Schaltungsträger 20 emittierende LED oder Laserdiode bzw. eine parallel zum Schaltungsträger 20 verlaufendes Licht detektierende Fotodiode auf.

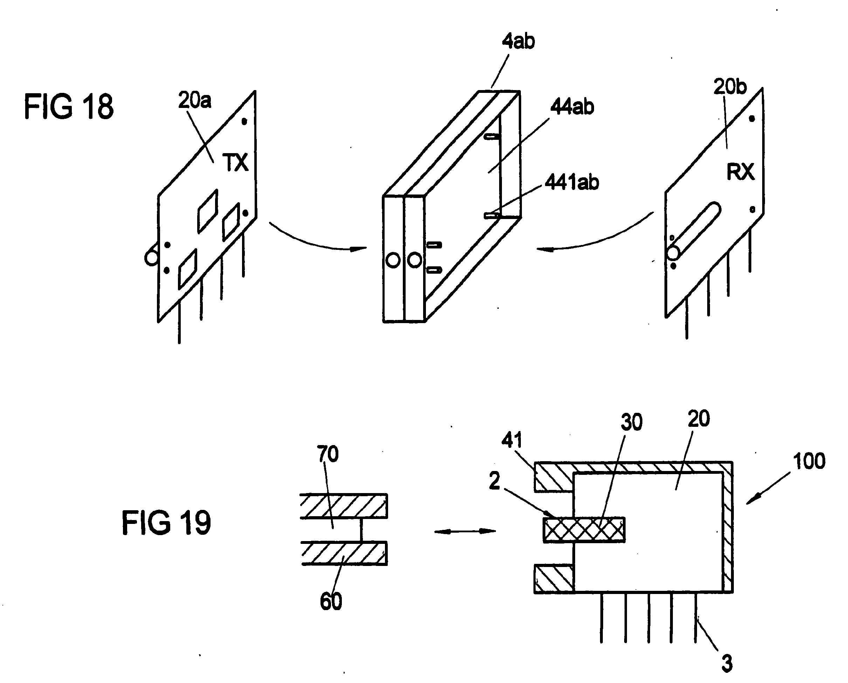

Die Figur 18 zeigt ein Ausführungsbeispiel, bei der eine erste Schaltungsplatine 20a mit einem Sendemodul und eine zweite Schaltungsplatine 20b mit einem Empfangsmodul in ein gemeinsames Gehäuse 4ab eingesetzt werden. Die Schaltungsträger 20a, 20b sind entsprechend Figur 13 ausgebildet. Nach einem Befestigen der Schaltungsträger an Positionier- und Haltepins 441ab einer mittleren Zwischenwand 42ab werden nicht gesondert dargestellte Abdeckungen an den beiden offenen Flächen des Gehäuses angebracht. Diese können ggf. wiederum Mittel zur Verbindung des Gehäuses mit weiteren Gehäusen enthalten. Durch geeignetes Platinendesign (großflächige Masseebenen) können die Abdeckungen auch entfallen. Dann befinden sich die Mittel zur Verbindung mit anderen Gehäusen am Gehäuse 4ab.

Die Figur 19 zeigt ein Ausführungsbeispiel, das die Verwirklichung des Kojiri-Kriteriums bei der Verbindung eines optischen Steckers mit der optischen Schnittstelle 2 des Bauelementes bereitstellt. Dabei ist vorgesehen, dass die optische Schnittstelle 2 gegenüber der Gehäuseseite 41, in der sie sich befindet, nach hinten versetzt angeordnet ist. Gleichzeitig ragt die optische Schnittstelle 2 über den Schaltungsträger 20 hinaus. Die Schnittstelle 2 wird beispielsweise durch einen starren Lichtwellenleiter (z.B. aus Glas oder Kunststoff) bereitgestellt. Der herausragende Teil stellt dabei eine Lichtwellenleiter-Verlängerung dar, die in diesem Fall die optische Schnittstelle bereitstellt. Alternativ kann die optische Schnittstelle auch durch einen vorstehenden Bereich der Schaltungsplatine gebildet werden, der den Lichtwellenleiter 30 enthält, so dass die Lichtwellenleiter-Verlängerung aus einem Stück Platine mit darauf angeordnetem Lichtwellenleiter besteht.

Das Kojiri-Kriterium wird insofern erfüllt, als der in einem anzukoppelnden optischen Stecker 60 angeordnete Lichtwellenleiter 70 im optischen Stecker 60 etwas zurückversetzt ist, um den Lichtwellenleiter 70 zu schützen. Beim Ankoppeln umfasst der Stecker 60 die Lichtwellenleiter-Verlängerung 2. Eine Verrastung zur Aufnahme von Kräften beim Stecken oder Ziehen des Steckers 60 erfolgt dabei trotzdem zwischen Stecker 60 und Gehäuse 41 (nicht gesondert dargestellt), so dass die Lichtwellenleiterverlängerung 2 keinen mechanischen Belastungen ausgesetzt ist.

Die dargestellte Verbindung stellt darüberhinaus eine sehr gute optische Kopplung direkt zwischen den beiden Lichtwellenleitern 2, 70 bereit, da wesentlich geringere Kopplungsverluste auftreten als bei einer Ankopplung des Steckers zunächst an das Gehäuse.

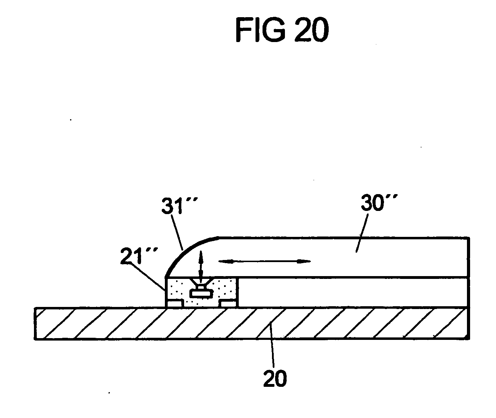

Die Figur 20 zeigt eine Ausführungsform, bei der das Sendeund/oder Empfangsmodul 21" nach oben abstrahlend ausgerichtet ist. Dementsprechend befindet sich der Lichtwellenleiter 30" beabstandet von dem Schaltungsträger 20. Der Lichtwellenleiter besteht bevorzugt aus einem klaren Kunststoffspritzteil, das im Bereich der Strahlumlenkung 31" eine Metallisierung oder eine andere geeignete Beschichtung mit einem Material geringerer Brechzahl aufweist, so dass das Licht zwischen Sende- und/oder Empfangsmodul 21" und Lichtwellenleiter 30" geeignet geführt wird. Mit Vorteil kommt diese Ausgestaltung ohne die Ausbildung einer Bohrung in dem Schaltungsträger 20 aus. Ein weiterer Vorteil besteht darin, dass der als Spritzgussteil ausgebildete Lichtwellenleiter so geformt werden kann, dass unmittelbar die Ankopplung eines optischen Steckers erfolgen kann.

In den Figuren 21a, 21b ist eine Ausgestaltung gemäß einem exemplarischen Ausführungsbeispiel der Erfindung dargestellt, bei der der Schaltungsträger des Bauelements 100' als MID-Schaltungsträger 200 ausgebildet ist (MID - moulded interconnected device). Die MID-Technologie erlaubt eine dreidimensionale Gestaltung eines Schaltungsträgers 200. Wie bereits erläutert, handelt es sich um ein aus Kunststoff gespritztes Formteil, das mit einem Laser derart modifiziert wird, dass direkt auf den Kunststoff Leiterbahnen ausgebildet sind. In dem Ausführungsbeispiel der Figuren 21a, 21b bildet der MID-Schaltungsträger 200, ggf. zusammen mit einer optionalen Abdeckung 400 (vgl. Figur 21b), das Gehäuse aus.

Der Schaltungsträger 200 weist dabei seitliche Balken 201 auf, die optional auch an den Stirnseiten ausgeführt sein können (gestrichelt dargestellt). Dabei entstehen Seitenflächen 200a, 200b an den Schmalseiten des Bauelements. Die Bestückung des Schaltungsträgers 200 mit einem optoelektronischen Modul 21 und elektrischen Bauteilen 22 erfolgt wie in bezug auf die Figuren 13 - 13c beschrieben, so dass insofern auf diese Figuren verwiesen wird. In einer rückseitigen Aussparung 202 des Schaltungsträgers 200 ist ein Lichtwellenleiter 30 vorgesehen, der an der einen schmalen Seite 200b des Bauelements 100' eine optischen Schnittstelle 2 bereitstellt. Die optische Schnittstelle 2 ist in einer Steckerbuchse 200b' der Schmalseite 200b angeordnet. Die Rückseite 203 des Schaltungsträgers 200 ist bis auf die Aussparung 202 flach ausgebildet und stellt die Gehäuserückseite dar.

In den MID-Schaltungsträger 200 sind in ein schmale Seite 200a elektrische Kontaktstifte 3 zur elektrischen Kontaktierung eingespritzt bzw. integriert.

Die zwischen den Balken 201 offene Oberseite 204 des Schaltungsträgers/Gehäuses 200 kann mit einer Abdeckung 400 entsprechend der Abdeckung der Figur 21b abgedeckt werden, alternativ mit einem Vergußmaterial vergossen werden. Optional kann auch vorgesehen sein, dass der bestückte MID-Träger 200 mit einer Schutzschicht bzw. einem Lack überzogen wird, so dass eine Abdeckung entfallen kann.

In einer Ausführungsvariante ist der MID-Träger 200 außen vollständig metallisiert.

Zwecks Bereitstellung eines modularen Systems sind auf den breiten Ober- und Unterseiten des Bauelements 100' bzw. des (durch den Schaltungsträger 200 gebildeten) Gehäuses schematisch dargestelle mechanische Verbindungselemente 57, 58 vorgesehen, die eine mechanische Verbindung mit weiteren Gehäusen erlauben. Mehrere solche miteinander verbundene Bauelemente 100' sind in Figur 21b dargestellt. Optional ist zusätzlich eine Abdeckung 400 für das außen liegenden Bauelement vorgesehen.

Die Verwendung eines MID-Schaltungsträgers weist den Vorteil auf, dass Gehäuse und Schaltungsträger kominiert sind. Die elektrischen Kontakte 3 sind in den Schaltungsträger einspritzbar. Auch kann eine Steckerbuchse 200b direkt in den Schaltungsträger integriert werden.

Die Erfindung beschränkt sich in ihrer Ausführung nicht auf die vorstehend dargestellten Ausführungsbeispiele. Beispielsweise kann vorgesehen sein, dass die Gehäuse für die optoelektronischen Bauelemente nicht an allen 6 Seiten abgeschlossen, sondern stattdessen an einer oder zwei Seiten offen ausgebildet sind. Beispielsweise ist das Gehäuse unten offen ausgebildet, wobei die Justage des Schaltungsträgers im Gehäuse dann nicht über Bohrungen erfolgt, sondern mittels Führungsnuten, entlang derer der Schaltungsträger von unten in das Gehäuse eingeschoben und positioniert wird.

Wesentlich für das in den Figuren 13 bis 21 beschriebene Bauelement ist, dass in das Bauelement ein Lichtwellenleiter integriert ist, der parallel zum Schaltungsträger verläuft und an einer schmalen Gehäuseseite eine optische Schnittstelle des Bauelementes zur Ein- und/oder Auskopplung von Licht ausbildet. Die elektrischen Kontakte des Bauelementes sind bevorzugt ebenfalls an einer schmalen Gehäuseseite angeordnet sein (die auch offen ausgebildet sein kann), um eine schmale Ausgestaltung zu gewährleisten.

## Patentansprüche

1. Optoelektronisches Bauelement mit
- einem Sende- und/oder Empfangsmodul (21),
- einem Schaltungsträger (200), auf dem das Sende- und/oder Empfangsmodul (21) angeordnet ist,
- einem Gehäuse, das durch den Schaltungsträger (200) ausgebildet wird,
wobei
- in das Bauelement (100') ein mit dem Sende- und/oder Empfangsmodul (21) gekoppelter Lichtwellenleiter (30) integriert ist, der parallel zu dem Schaltungsträger (200) verläuft und an einer schmalen Gehäuseseite (200b) eine optische Schnittstelle (2) des Bauelements zur Ein- und/oder Auskopplung von Licht ausbildet, und
- die elektrischen Kontakte (3) des Bauelements (100') ebenfalls an einer schmalen Gehäuseseite (200a) angeordnet sind,
wobei
das Bauelement eine Abdeckung (400) aufweist, die Mittel zur mechanischen Verbindung mit dem durch den Schaltungsträger (200) gebildeten Gehäuse aufweist;
der Schaltungsträger (200) Balken (201) aufweist, womit Seitenflächen (200a, 200b) an Schmalseiten des Bauelements gebildet sind, wobei eine zwischen den Balken (201) offene Oberseite (204) des Schaltungsträgers (200) mit der Abdeckung (400) abdeckbar ist;
zwecks Bereitstellung eines modularen Systems auf einer breiten Unterseite des durch den Schaltungsträger (200) gebildeten Gehäuses und auf den Balken (201) auf einer breiten Oberseite des durch den Schaltungsträger (200) gebildeten Gehäuses Mittel (57, 58) zur mechanischen Verbindung mit mindestens einem Gehäuse eines weiteren Bauelements oder mit der Abdeckung (400) vorgesehen sind.

2. Bauelement nach Anspruch 1, **dadurch gekennzeichnet, dass** die Mittel zur mechanischen Verbindung als mechanische Verbindungselemente (57, 58) ausgebildet sind, die eine steckbare Verbindung mit einem vergleichbaren Gehäuse eines weiteren Bauelements ermöglichen.

3. Bauelement nach Anspruch 1 oder 2, **dadurch gekennzeichnet, dass** die mechanischen Verbindungselemente (57, 58) als Rastelemente (57, 58), als Formschlußclemente oder Befestigungsstifte ausgebildet sind.

4. Bauelement nach mindestens einem der vorangehenden Ansprüche, **dadurch gekennzeichnet, dass** das Bauelement eine maschinenlesbare Beschriftung aufweist.

5. Bauelement nach mindestens einem der vorangehenden Ansprüche, **dadurch gekennzeichnet, dass** das Bauelement eine farbliche Kennzeichnung aufweist, die seine Zugehörigkeit zu einer bestimmten Klasse von Bauelementen oder seine mechanische Verbindbarkeit mit anderen Bauelementen angibt.

6. Bauelement nach mindestens einem der vorangehenden Ansprüche, **dadurch gekennzeichnet, dass** das Gehäuse quaderförmig mit vier schmalen Seiten und zwei breiten Seiten ausgebildet ist.

7. Bauelement nach mindestens einem der vorangehenden Ansprüche, **dadurch gekennzeichnet, dass** die elektrischen Kontakte (3) des Bauelements (100') an einer schmalen Seite (200a) des Gehäuses angeordnet sind, die senkrecht zu der schmalen Seite (200b) mit der optischen Schnittstelle (2) verläuft.

8. Bauelement nach mindestens einem der vorangehenden Ansprüche, **dadurch gekennzeichnet, dass** das Sende- und/oder Empfangsmodul (21) auf der einen Seite des Schaltungsträgers (200) und der Lichtwellenleiter (30) auf der anderen Seite des Schaltungsträgers (200) angeordnet ist, wobei die optische Achse des Sende- und/oder Empfangsmoduls senkrecht zum Schaltungsträger verläuft und empfangenes oder ausgesandtes Licht den Schaltungsträger im Bereich einer Aussparung (24) desselben durchstrahlt und in den Lichtwellenleiter (30) ein- oder ausgekoppelt wird.

9. Bauelement nach Anspruch 8, **dadurch gekennzeichnet, dass** in der Aussparung (24) des Schaltungsträgers (20) eine Linse (50) angeordnet ist.

10. Bauelement nach mindestens einem der Ansprüche 1 bis 7, **dadurch gekennzeichnet, dass** das Sende- und/oder Empfangsmodul (21') und der Lichtwellenleiter (30') auf der gleichen Seite des Schaltungsträgers (20) angeordnet sind, wobei das Sende- und/oder Empfangsmodul (20') parallel zum Schaltungsträger (20) Licht aussendet und/oder empfängt.

11. Bauelement nach mindestens einem der Ansprüche 1 bis 7, **dadurch gekennzeichnet, dass** das Sende- und/oder Empfangsmodul (21") und der Lichtwellenleiter (30") auf der gleichen Seite des Schaltungsträgers (20) angeordnet sind, wobei die optische Achse des Sende- und/oder Empfangsmoduls (21") senkrecht zum Schaltungsträger (20) verläuft und empfangenes oder ausgesandtes Licht durch eine Strahlumlenkung (31") in den beabstandet zum Schaltungsträger (20) verlaufenden Lichtwellenleiter (30") ein- oder ausgekoppelt wird.

12. Bauelement nach mindestens einem der vorangehenden Ansprüche, **dadurch gekennzeichnet, dass** das Bauelementgehäuse einen umlaufenden, die Schmalseiten definierenden Rahmen (41) aufweist.

13. Bauelement nach mindestens einem der vorangehenden Ansprüche, **dadurch gekennzeichnet, dass** die an der einen schmalen Gehäuseseite (41, 200b) ausgebildete optische Schnittstelle (2) eine in die Schmalseite (41, 200b) integrierte Steckeraufnahme (200b') zur Ankopplung eines optischen Steckers aufweist.

14. Bauelement nach mindestens einem der vorangehenden Ansprüche, **dadurch gekennzeichnet, dass** das Bauelement zwei Schaltungsträger (20a, 20b) mit jeweils integriertem Lichtwellenleiter aufweist, die in ein gemeinsames Gehäuse (4ab) eingebracht sind, wobei der eine Schaltungsträger (20a, 20b) ein Sendemodul und der andere Schaltungsträger (20b, 20a) ein Empfangsmodul trägt, und wobei die beiden zugehörigen optischen Schnittstellen (2) an der gleichen schmalen Seite des Gehäuses (4ab) ausgebildet sind.

15. Bauelement nach mindestens einem der vorangehenden Ansprüche, **dadurch gekennzeichnet, dass** die optische Schnittstelle eines an das Bauelement anzukoppelnden Steckers (60) gegenüber der Stecker-Stirnfläche zurückversetzt ist und am Bauelement Strukturen (2, 30) zur Aufnahme eines solchen Steckers ausgebildet sind.

16. Bauelement nach mindestens einem der Ansprüche 1 bis 15, **dadurch gekennzeichnet, dass** der Lichtwellenleiter (30, 30', 30") durch direkte Strukturierung einer auf den Schaltungsträger (20, 200) aufgebrachten Kunststoffschicht mittels Laser, durch Aufkleben einer Standard-Lichtleitfaser oder durch Aufbringen eines Plastik-Wellenleiters auf den Schaltungsträger (20, 200) hergestellt ist.

## Claims

1. An opto-electronic component with
- a transmitter and/or receiver module (21),
- a circuit board (200), on which the transmitter and/or receiver module (21) is arranged,
- a housing, which is formed by the circuit board (200), wherein
- an optical waveguide (30) coupled with the transmitter and/or receiver module (21) is integrated into the component (100'), which optical waveguide is aligned parallel to the circuit board (200) and on a narrow side of the housing (200b) forms an optical interface (2) of the component for the coupling in and/or out of light, and
- the electrical contacts (3) of the component (100) are likewise arranged on a narrow side of the housing (200a), wherein
the component has a cover (400), which has means for mechanical connection with the housing formed by the circuit board (200);
the circuit board (200) has bars (201) with which side faces (200a, 200b) are formed on narrow sides of the component, wherein an open upper side (204) of the circuit board (200) between the bars (201) can be covered with the cover (400);
for the purposes of providing a modular system, means (57, 58) are provided on a wide under side of the housing formed by the circuit board (200) and on the bars (201) on a wide upper side of the housing formed by the circuit board (200) for the mechanical connection with at least one housing of a further component or with the cover (400).

2. The component according to Claim 1,
**characterised in that** the means for mechanical connection are designed as mechanical connecting elements (57, 58), which enable a pluggable connection with a comparable housing of a further component.

3. The component according to Claim 1 or 2,
**characterised in that** the mechanical connecting elements (57, 58) are designed as engaging elements (57, 58), as form closure elements, or attachment pins.

4. The component according to at least one of the preceding claims,
**characterised in that** the component has an inscription that can be read by machine.

5. The component according to at least one of the preceding claims,
**characterised in that** the component has a coloured form of identification, which specifies a membership of the component to a particular class of components, or a mechanical connectability of the component with other components.

6. The component according to at least one of the preceding claims,
**characterised in that** the housing is designed as a cuboid shape with four narrow sides and two wide sides.

7. The component according to at least one of the preceding claims,
**characterised in that** the electrical contacts (3) of the component (100') are arranged on a narrow side of the housing (200a), which narrow side is aligned perpendicular to the narrow side (200b) with the optical interface (2).

8. The component according to at least one of the preceding claims,
**characterised in that** the transmitter and/or receiver module (21) is arranged on one side of the circuit board (200) and the optical waveguide (30) is arranged on the other side of the circuit board (200), wherein
the optical axis of the transmitter and/or receiver module is aligned perpendicular to the circuit board and received or transmitted light passes through the circuit board in the region of a recess (24) of the same and is coupled in or out of the optical waveguide (30).

9. The component according to Claim 8,
**characterized in that** a lens (50) is arranged in the recess (24) of the circuit board (20).

10. The component according to at least one of the Claims 1 to 7,
**characterised in that** the transmitter and/or receiver module (21') and the optical waveguide (30') are arranged on the same side of the circuit board (20), wherein
the transmitter and/or receiver module (20') transmits and/or receives light parallel to the circuit board (20).

11. The component according to at least one of the Claims 1 to 7,
**characterised in that** the transmitter and/or receiver module (21") and the optical waveguide (30") are arranged on the same side of the circuit board (20), wherein
the optical axis of the transmitter and/or receiver module (21") is aligned perpendicular to the circuit board (20) and received or transmitted light is coupled in or out through a beam deflector (31") in the optical waveguide (30") set at a distance from the circuit board (20).

12. The component according to at least one of the preceding claims,
**characterized in that** the component housing has a peripheral frame (41) defining the narrow sides.

13. The component according to at least one of the preceding claims,
**characterised in that** the optical interface (2) designed on the one narrow housing side (41, 200b) has a connector holder (200b') integrated into the narrow side (41, 200b) for the coupling of an optical connector.

14. The component according to at least one of the preceding claims,
**characterised in that** the component has two circuit boards (20a, 20b), in each case with an integrated optical waveguide, which are introduced into a common housing (4ab), wherein
the one circuit board (20a, 20b) carries a transmitter module and the other circuit board (20b, 20a) carries a receiver module, and wherein
the two related optical interfaces (2) are designed on the same narrow side of the housing (4ab).

15. The component according to at least one of the preceding claims,
**characterised in that** the optical interface of a connector (60) to be coupled to the component is arranged backward relative to the connector end face and
**in that** structures (2, 30) to hold such a connector are designed on the component.

16. The component according to at least one of the Claims 1 to 15,
**characterised in that** the optical waveguide (30, 30', 30") is manufactured by direct pattering of a plastic layer applied to the circuit board (20, 200) by means of a laser, by an adhesive bonding of a standard optical waveguide, or by the application of a plastic waveguide on to the circuit board (20, 200).

## Revendications

1. Composant optoélectronique comprenant
- un module d'émission et/ou de réception (21),
- un support de circuit (200), sur lequel est disposé le module d'émission et/ou de réception (21),
- un boîtier, qui est formé par le support de circuit (200),
dans lequel
- un guide d'ondes optiques (30) couplé au module d'émission et/ou de réception (21), qui s'étend de manière parallèle au support de circuit (200) et forme sur un côté étroit du boîtier (200b) une interface optique (2) du composant pour le couplage et/ou le découplage de lumière, est intégré dans le composant (100'), et
- les contacts électriques (3) du composant (100') sont également disposés sur un côté étroit du boîtier (200a),
dans lequel
le composant présente un couvercle (400) qui comprend des moyens pour un raccordement mécanique avec le boîtier formé par le support de circuit (200) ;
le support de circuit (200) présente des barres (201) au moyen desquelles sont formées des surfaces latérales (200a, 200b) sur les côtés étroits du composant, un côté supérieur ouvert (204) entre les barres (201) du support de circuit (200) pouvant être recouvert par le couvercle (400) ;
en vue de la mise à disposition d'un système modulaire sur un côté inférieur large du boîtier formé par le support de circuit (200) et sur les barres (201) sur une face supérieure large du boîtier formé par le support de circuit (200), des moyens (57, 58) destinés au raccordement mécanique avec au moins un boîtier d'un autre composant ou avec le couvercle (400) sont prévus.

2. Composant selon la revendication 1, **caractérisé en ce que** les moyens pour le raccordement mécanique sont conçus sous la forme d'éléments de raccordement mécaniques (57, 58), qui permettent un raccordement enfichable avec un boîtier comparable d'un autre composant.

3. Composant selon la revendication 1 ou 2, **caractérisé en ce que** les éléments de raccordement mécaniques (57, 58) sont conçus sous la forme d'éléments d'encliquetage (57, 58), d'éléments à engagement par complémentarité de forme ou de chevilles de fixation.

4. Composant selon au moins l'une quelconque des revendications précédentes, **caractérisé en ce que** le composant présente une inscription lisible par ordinateur.

5. Composant selon au moins l'une quelconque des revendications précédentes, **caractérisé en ce que** le composant présente un marquage coloré, qui indique son appartenance à une classe déterminée de composants ou sa capacité de raccordement mécanique à d'autres composants.

6. Composant selon au moins l'une quelconque des revendications précédentes, **caractérisé en ce que** le boîtier est conçu sous une forme parallélépipédique avec quatre côtés étroits et deux côtés larges.

7. Composant selon au moins l'une quelconque des revendications précédentes, **caractérisé en ce que** les contacts électriques (3) du composant (100') sont disposés sur un côté étroit (200a) du boîtier qui s'étend de manière perpendiculaire au côté étroit (200b) avec l'interface optique (2).

8. Composant selon au moins l'une quelconque des revendications précédentes, **caractérisé en ce que** le module d'émission et/ou de réception (21) est disposé sur un côté du support de circuit (200) et le guide d'ondes optiques (30) sur l'autre côté du support de circuit (200), l'axe optique du module d'émission et/ou de réception s'étendant de manière perpendiculaire au support de circuit et la lumière émise ou reçue rayonnant à travers le support de circuit dans la zone d'un évidement (24) de celui-ci et étant couplée ou découplée dans le guide d'ondes optiques (30).

9. Composant selon la revendication 8, **caractérisé en ce qu'**une lentille (50) est disposée dans l'évidement (24) du support de circuit (20).

10. Composant selon au moins l'une quelconque des revendications 1 à 7, **caractérisé en ce que** le module d'émission et/ou de réception (21') et le guide d'ondes optiques (30') sont disposés sur le même côté du support de circuit (20), le module d'émission et/ou de réception (20') émettant et/ou recevant la lumière parallèlement au support de circuit (20).

11. Composant selon au moins l'une quelconque des revendications 1 à 7, **caractérisé en ce que** le module d'émission et/ou de réception (21") et le guide d'ondes optiques (30") sont disposés sur le même côté du support de circuit (20), l'axe optique du module d'émission et/ou de réception (21") s'étendant de manière perpendiculaire au support de circuit (20) et la lumière reçue ou émise étant couplée ou découplée par une déviation de faisceau dans le guide d'ondes optiques (30") s'étendant à une certaine distance du support de circuit (20).

12. Composant selon au moins l'une quelconque des revendications précédentes, **caractérisé en ce que** le boîtier du composant présente un cadre (41) périphérique, définissant les côtés étroits.

13. Composant selon au moins l'une quelconque des revendications précédentes, **caractérisé en ce que** l'interface optique (2) formée sur un côté étroit du boîtier (41, 200b) présente un logement de connecteur (200b') intégré dans le côté étroit (41, 200b), destiné au couplage d'un connecteur optique.

14. Composant selon au moins l'une quelconque des revendications précédentes, **caractérisé en ce que** le composant présente deux supports de circuit (20a, 20b) comprenant respectivement un guide d'ondes optiques intégré, qui sont mis en place dans un boîtier commun (4ab), le premier support de circuit (20a, 20b) portant un module d'émission et l'autre support de circuit (20a, 20b) portant un module de réception, et les deux interfaces optiques (2) associées étant formées sur le même côté étroit du boîtier (4ab).

15. Composant selon au moins l'une quelconque des revendications précédentes, **caractérisé en ce que** l'interface optique d'un connecteur (60) à coupler au composant est reculée par rapport à la surface frontale du connecteur et des structures (2, 30) sont réalisées sur le composant pour loger un tel connecteur.

16. Composant selon au moins l'une quelconque des revendications 1 à 15, **caractérisé en ce que** le guide d'ondes optiques (30, 30', 30") est fabriqué par le biais de la structuration directe d'une couche de plastique appliquée sur le support de circuit (20, 200) au moyen d'un laser, du collage d'une fibre de guidage de lumière standard ou de l'application d'un guide d'ondes pour plastique sur le support de circuit (20, 200).
